# DEMANDE DE BREVET EUROPEEN

(11) **EP 0 716 313 A1**
(43) Date de publication de la demande: **12.06.1996**
(21) Numéro de dépôt: 95402757.9
(22) Date de dépôt: 07.12.1995
(51) Int. Cl.: G01R 33/28, G01R 33/60

(54) **Spectromètre à résonance paramagnétique électronique pour la dosimétrie d'irradiation**

(30) Priorité: 09.12.1994 FR 9414847
(71) Demandeur: COMMISSARIAT A L'ENERGIE ATOMIQUE, F-75015 Paris (FR)
(72) Inventeur: Duret, Denis, F-38100 Grenoble (FR); Guilhamat, Bernard, F-38590 Saint-Michel-de-Saint-Geoirs (FR); Moussavi, Mehdi, F-38240 Meylan (FR)
(74) Mandataire: Moutard, Pascal

(57) **Abrégé**

L'invention a pour objet un spectromètre à RPE, sans gradient de champ, comportant :
- des moyens (4) de production d'un champ magnétique,
- au moins une antenne plane (8) disposée sur un corps (2) à étudier,
- des moyens (10) de transmission, à l'antenne, de signaux radiofréquences,
- des moyens de réception de signaux basse fréquence réémis par le corps en réponse à l'excitation RPE,
- des moyens (14, 16) de traitement et d'analyse des signaux basse fréquence reçus par les moyens de réception,
- des moyens (18) pour représenter une image (20) du corps étudié, à partir des signaux traités et analysés par les moyens de traitement et d'analyse.

## Description

### Domaine technique

La présente invention se rapporte au domaine de la spectrométrie à résonance paramagnétique électronique (RPE) pour la dosimétrie d'irradiation.

La technique de dosimétrie par RPE est habituellement mise en oeuvre en combinaison avec un marqueur radicalaire sensible aux irradiations, comme la L-α-alanine. Les objets étudiés peuvent être par exemple des aliments, afin de contrôler des doses d'irradiation reçues par ceux-ci : une telle utilisation est décrite dans l'article de J. RAFFI et al. intitulé "Electron Spin Resonance Identification of Irradiated Fruit" paru dans Radiat. Phys. Chem., vol.34, n°6, pp. 891-894, 1989. Cette technique a également été appliquée à la dosimétrie d'irradiation chez l'homme, mais uniquement sur les dents : cette application est décrite dans l'article de H. ISHII et al., paru dans Japanese Journal of Applied Physics, vol. 29, n°5, mai 1990, pages 871 à 875.

On peut classer les appareils existants pour réaliser ce type de mesure en deux catégories, en fonction de la fréquence utilisée. Les appareils fonctionnant à haute fréquence présentent un électroaimant de taille importante nécessitant un refroidissement. Ils ne sont pas portables et nécessitent l'acheminement des échantillons du lieu d'irradiation jusqu'au lieu de mesure. De plus, du fait de la fréquence (en général, de l'ordre de 9 GHz), l'épaisseur de pénétration de la fréquence dans le corps à étudier est limitée. Cette profondeur est de 5 mm à 9 GHz, et elle est encore plus faible lorsque l'échantillon contient un liquide polaire comme l'eau, ce qui est le cas de la plupart des tissus vivants ou des fruits. Enfin, une cavité unique, à l'intérieur de laquelle l'échantillon est placé, est utilisée pour l'excitation et la détection : cette cavité joue le rôle d'antenne. La cavité standard est de forme cylindrique, ce qui nécessite un confinement spécial de l'échantillon. Actuellement les échantillons sont contenus dans des tubes de 5 mm d'épaisseur maximum.

Les appareils fonctionnant à basse fréquence (de l'ordre de 300 MHz) ont des antennes du type "selle de cheval" ou "loop-gap" qui jouent le rôle d'excitation et de détection et qui présentent une symétrie selon l'axe de l'échantillon. Le coefficient de remplissage de l'antenne est faible (autrement dit le rayonnement de l'antenne est limité), car celle-ci est éloignée de l'échantillon. Or son fonctionnement nécessite une puissance d'émission d'autant plus importante que son coefficient de remplissage est faible. De ce faible coefficient de remplissage résulte un rendement faible pour les échantillons ou corps à faibles densités radicalaires.

Dans tous les cas, cette technique ne permet pas d'obtenir une image fonctionnelle, mais uniquement une réponse globale, et ne permet pas de localiser des zones irradiées.

### Exposé de l'invention

La présente invention cherche à résoudre les problèmes posés par les appareils et les procédés selon l'art antérieur, et notamment le problème du faible rendement obtenu avec les appareils classiques dans le cas de corps présentant de faibles densités radicalaires, ainsi que le problème de la localisation des zones irradiées.

A cet effet, l'invention a pour objet un spectromètre à résonance paramagnétique électronique pour la dosimétrie d'irradiation d'un corps, sans gradient de champ magnétique, caractérisé en ce qu'il comporte :
- des moyens de production d'un champ magnétique,
- au moins une antenne plane, destinée à être disposée sur ledit corps,
- des moyens de transmission, à l'antenne plane, de signaux radiofréquence, pour exciter une résonance paramagnétique électronique dudit corps,
- des moyens de réception de signaux basse fréquence réémis par ledit corps en réponse à l'excitation d'une résonance paramagnétique électronique (RPE),
- des moyens de traitement et d'analyse des signaux reçus par les moyens de réception,
- des moyens pour représenter une image du niveau d'irradiation d'au moins une partie du corps à partir des signaux traités et analysés par les moyens de traitement et d'analyse.

Les antennes utilisées avec l'appareil selon l'invention sont des antennes de surface, qui offrent un meilleur rendement que les cavités utilisées dans les appareils selon l'art antérieur, notamment lorsque sont étudiés des corps à faible densité radicalaire. En effet, avec une antenne de surface, telle que par exemple une antenne circulaire, on ne s'intéresse à chaque acquisition qu'au volume délimité par la demi-sphère ayant le même diamètre que l'antenne. On peut ainsi décrire tout le volume de l'échantillon, soit en déplaçant l'antenne, soit en faisant une acquisition simultanée à l'aide de plusieurs antennes. La technique d'imagerie consistant en une représentation de la cartographie des radicaux présents dans le corps devient alors possible, avec un temps d'acquisition faible grâce au traitement en parallèle des données. Dans une cavité classique, on s'intéresse à tout le volume de l'échantillon à chaque acquisition, et les signaux obtenus ne sont pas localisés au sein de cet échantillon.

L'absence de gradient de champ offre en outre une simplification considérable, puisque des bobines de création de ces gradients n'ont pas besoin d'être prévues, pas plus que des moyens pour contrôler et piloter ces bobines.

L'acquisition des données spectroscopiques peut être faite :
- point par point à l'aide d'une antenne que l'on déplace sur le corps à examiner, et/ou
- par un réseau d'antennes transmettant simultanément leurs signaux.

Si un réseau d'antennes est utilisé, il peut être déplacé sur la zone d'intérêt du corps.

Un type d'antenne plane particulièrement adaptée à l'invention est une antenne spiralée.

Un autre problème résolu par l'invention, selon un mode particulier de réalisation, est celui de la pénétration de l'excitation RPE à l'intérieur du corps étudié. Pour cela, au moins une partie des signaux radiofréquence transmis à l'antenne a une fréquence inférieure à 1 GHz.

On résout le problème de l'application de ces signaux à un corps contenant de l'eau (et donc à un corps humain ou à une entité biologique telle qu'un fruit) en choisissant des signaux radiofréquence transmis à l'antenne, dont la répartition spectrale est entièrement comprise dans un domaine inférieur à 1 GHz. Ledit domaine peut être par exemple compris entre 250 et 600 MHz.

Selon un mode particulier de réalisation de l'invention, le spectromètre comporte au moins une antenne qui assure la double fonction d'excitation et de détection.

Le spectromètre peut comporter également plusieurs antennes qui assurent alors soit la double fonction d'excitation et de détection, soit indépendamment une fonction d'excitation ou une fonction de détection.

Selon un mode particulier de réalisation, il est possible d'utiliser une antenne d'émission et plusieurs antennes de détection disposées en divers points du corps à étudier. Le temps d'acquisition des données nécessaires à l'établissement d'une image de l'entité radicalaire du corps étudié est alors diminué.

Selon une autre variante, il est possible d'utiliser une antenne d'émission et une antenne de détection en chaque point de mesure sur le corps. Ceci est beaucoup plus rapide que dans les techniques dans lesquelles on a recours à l'application de champs de gradients pour sélectionner des zones à l'intérieur du corps dont on veut établir l'image, puisqu'il faut alors faire des acquisitions successives avant de pouvoir reconstituer l'image.

Selon un autre mode particulier de réalisation, dans le cas où l'on utilise plusieurs antennes, celles-ci peuvent être intégrées sur un même support, tel qu'un support rigide ou un support souple. Le support peut être lui-même déplacé sur la zone d'intérêt du corps étudié.

Les antennes (d'excitation et/ou de détection) peuvent être associées à des moyens d'accord en fréquence, par exemple des condensateurs d'accord et des diodes à capacité variable.

Afin d'avoir le moins de perte de signal possible, ces éléments sont intégrés à proximité préférentiellement des antennes ou sinon à proximité des moyens de réception et de transmission.

On peut également utiliser, comme moyens d'accord une capacité mécanique ou motorisée, ou bien une capacité piézoélectrique.

Les procédés d'imagerie RPE selon l'art antérieur présentent des problèmes équivalents à ceux évoqués ci-dessus, en liaison avec les appareils d'imagerie RPE selon l'art antérieur. Par conséquent, l'invention a également pour objet un procédé qui permet de résoudre le problème du faible rendement d'excitation dans le cas de faibles densités radicalaires, ainsi que le problème de la localisation des zones irradiées.

Le procédé d'imagerie par résonance paramagnétique électronique d'un corps sans gradient de champ magnétique est caractérisé en ce qu'il comporte les étapes suivantes :
- introduction d'au moins une partie du corps dans un champ magnétique,
- application à ce corps de signaux radiofréquence à l'aide d'une ou de plusieurs antennes planes pour exciter une ou des résonances paramagnétiques électroniques RPE dudit corps,
- réception de tout ou partie de signaux basse fréquence réémis par le corps en réponse à l'excitation RPE, à l'aide de moyens de réception de signaux basse fréquence,
- traitement et analyse des signaux reçus en vue de former une image de ladite partie du corps,
- affichage de cette image.

On entend par image toute représentation graphique permettant de relier les points de mesure au corps étudié.

Selon un mode particulier de réalisation, les signaux radiofréquence pour exciter la ou les RPE dans le corps étudié ont une répartition spectrale située au moins en partie en-dessous de 1 GHz.

Selon un mode encore plus particulier de réalisation, ces signaux ont une répartition spectrale comprise entièrement en-dessous de 1GHz, en particulier entre 250 et 600 MHz.

Il est possible d'utiliser une antenne d'émission et plusieurs antennes de détection, ce qui permet d'éviter la lenteur des procédés d'imagerie RPE selon l'art antérieur. Selon une variante, il est possible d'utiliser, pour chaque point de mesure sur le corps étudié, une antenne d'émission et une de détection.

### Brève description des figures

De toute façon, les caractéristiques et avantages de l'invention apparaîtront mieux à la lumière de la description qui va suivre. Cette description porte sur les exemples de réalisation, donnés à titre explicatif et non limitatif, en se référant à des dessins annexés sur lesquels :
- la figure 1 est une représentation schématique et fonctionnelle d'un appareil selon la présente invention,
- la figure 2 est une représentation schématique de la commande d'une antenne dans un appareil selon la présente invention,
- la figure 3 est une représentation schématique d'un exemple de chaîne électronique RF pour une antenne, utilisable dans le cadre de l'invention,
- la figure 4 est la représentation d'une chaîne électronique RF pour un système à pilote unique, commun à plusieurs antennes, utilisable dans le cadre de la présente invention,
- la figure 5 représente une antenne multiple à 4 antennes spiralées sur support rigide,
- la figure 6 est une représentation schématique de la commande d'un aimant,
- la figure 7 représente schématiquement des moyens de commande
- les figures 8a et 8b sont des exemples de spectres mesurés chacun en un point.

### Description détaillée de modes de réalisation de l'invention

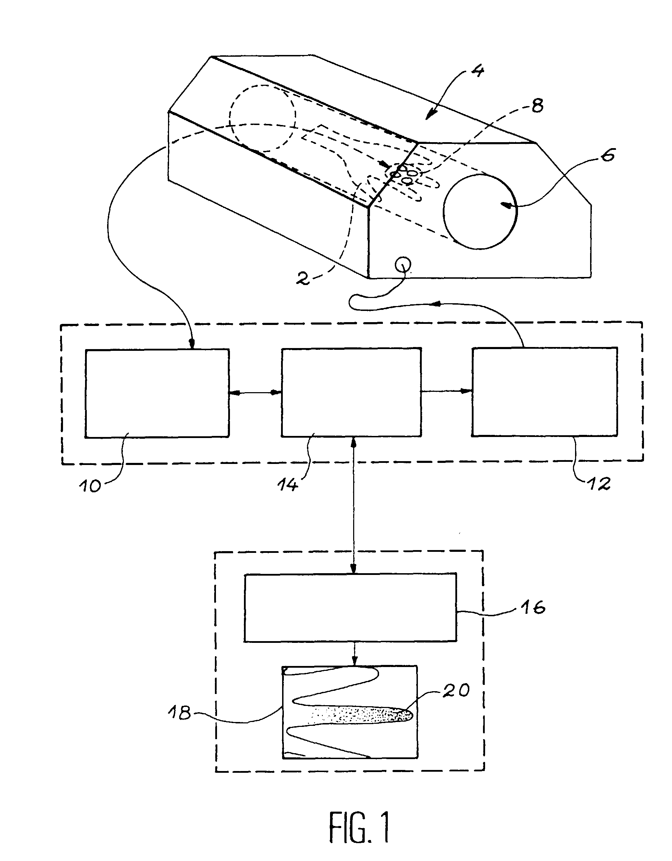

Une représentation schématique et fonctionnelle d'un appareil conforme à la présente invention est illustrée figure 1. Sur cette figure, la référence 2 désigne un corps à analyser ou, plus précisément, un corps qui a été irradié et pour lequel on veut obtenir une représentation bidimensionnelle de la répartition des zones irradiées. Sur l'exemple de la figure 1, il s'agit d'une main. Ce peut-être également toute autre partie du corps humain ou toute autre partie d'un corps d'origine biologique, tel que par exemple un fruit. Ce corps est introduit dans un appareil 4 tel qu'un électroaimant, qui est piloté par des moyens de commande 12, et qui permet de générer un champ magnétique homogène, modulé par un champ basse fréquence dont l'amplitude est adaptée à la largeur de raie RPE d'un radical contenu dans le corps 2. Sur la figure 1, l'électroaimant 4 présente une ouverture 6 qui permet de plonger ledit corps à l'intérieur du champ magnétique.

Par ailleurs, on dispose en contact avec ce corps une antenne plane ou un réseau 8 d'antennes plane(s), accordée(s) sur la radiofréquence choisie. Le nombre d'antennes peut évoluer en fonction de la résolution désirée et/ou de la taille de l'échantillon à étudier. Les antennes peuvent être à simple fonction, c'est-à-dire émission ou détection, ou à double fonction, émission et détection. Il est ainsi possible d'utiliser une antenne d'émission commune à toutes les antennes de détection (avec une antenne de détection par point de mesure) ou d'utiliser pour chaque point de mesure deux antennes respectivement d'émission et de détection ou encore pour chaque point de mesure une antenne assurant à la fois l'émission et la détection. La ou les antennes sont pilotées par des moyens de commande (i.e. les moyens de transmission et de réception) combinés à des moyens de traitement analogique des signaux mesurés, et désignés globalement par la référence 10 sur la figure 1. Des moyens 14 de commande et de traitement numérique permettent de commander les moyens 10, 12. Ils sont eux-mêmes pilotés par des moyens de traitement informatique 16, qui reçoivent par ailleurs des signaux mesurés et traités par l'intermédiaire des moyens de traitement numérique 14. Les moyens de traitement informatique 16 permettent de reconstituer, à partir des données reçues, une image 20 d'une partie du corps 2 à étudier, image qui est représentée sur un écran 18. Dans le cas où plusieurs antennes sont utilisées pour la réception des signaux, ces derniers peuvent être acquis simultanément, ce qui est plus rapide que par les techniques connues mettant en oeuvre des champs de gradients.

La gamme de fréquences d'excitation est choisie en particulier en fonction de la profondeur d'investigation du corps 2 à étudier. Dans la mesure où la plupart des corps à étudier sont des corps d'origine biologique, donc présentant une importante proportion d'eau, il est préférable de ne pas utiliser des fréquences au-delà de 1 GHz. Un domaine de fréquences particulièrement intéressant est le domaine 250-600 MHz, et en particulier la fréquence 560 MHz qui correspond à un champ de 200 Gauss pour la résonance électronique RPE (champ et fréquence sont liés par la relation de Larmor ωₒ = γBₒ avec ωₒ/2π = fréquence de résonance, Bₒ = champ magnétique, γ = rapport gyromagnétique de l'électron qui est une constante = 2,8 MHz/Gauss) ou de 280 MHz, qui correspond à un champ de 100 Gauss.

Comme, par ailleurs, la diminution de la fréquence s'accompagne, en général, non seulement d'une profondeur de pénétration plus grande dans le corps mais également d'une perte de sensibilité, ces domaines de fréquences sont particulièrement bien adaptés pour des parties du corps dont l'investigation est réalisée à une profondeur d'environ quelques mm à quelques cm. Le principe de l'invention permet alors d'obtenir une image fonctionnelle avec une résolution de quelques mm³, pour des radiofréquences ne dépassant pas 1 GHz.

Plusieurs modes d'excitation radiofréquence peuvent être envisagés. Le choix du mode dépend de la manière dont est fait l'accord automatique de fréquence, globalement pour l'ensemble des antennes, par action sur un pilote radiofréquence (c'est-à-dire sur l'élément qui génère le champ radiofréquence, par exemple un oscillateur), ou individuellement en agissant sur une diode à capacité variable commandant l'accord de chaque antenne.

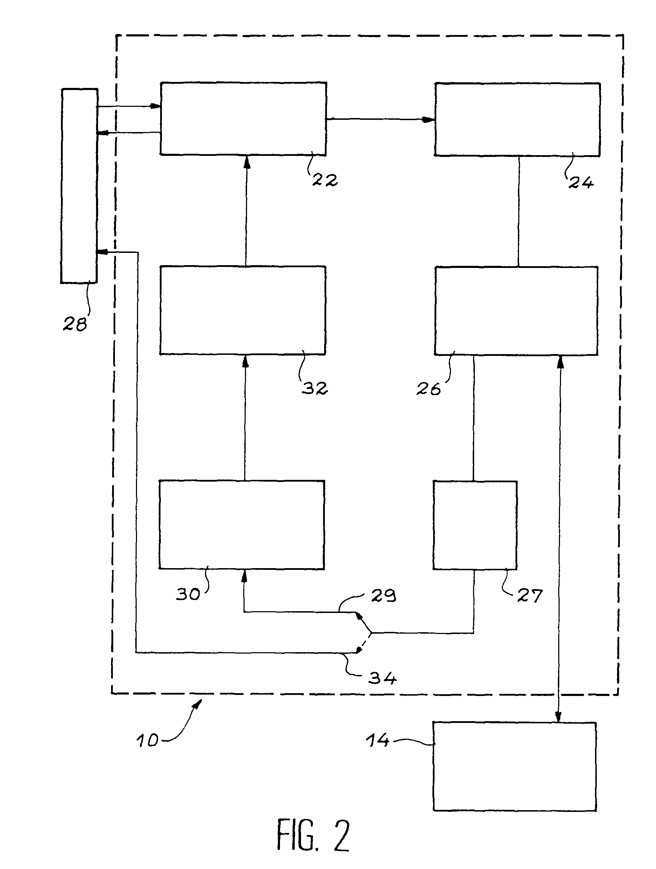

Une représentation schématique des moyens de commande et de traitement analogique 10 est donnée sur la figure 2. Sur cette figure, la référence 28 désigne une antenne plane destinée à être en contact avec un corps à examiner. Sur cette figure, la référence 27 désigne un amplificateur d'erreur. Celui-ci contrôle soit la tension d'un oscillateur (VCO) 30, soit une diode à capacité variable (appelée encore VARICAP) qui est alors incluse dans les moyens 28.

L'oscillateur ou générateur 30 contrôlé en tension agit sur la fréquence RF, qui peut être fixe lorsque l'accord de l'antenne est réalisée à partir de la diode ou variable lorsque l'accord se fait à partir de la fréquence RF. Le signal radiofréquence est ensuite transmis à des moyens 32 de traitement du signal RF, afin de mettre en forme les impulsions radiofréquences qui peuvent être transmises à l'antenne. Cette dernière est alimentée par l'intermédiaire de moyens 22 d'injection du signal d'excitation. Ces moyens 22 sont aptes également à recevoir des signaux basse fréquence, réémis par le corps 2 après excitation RPE, et qui contiennent l'information à partir de laquelle l'image de la répartition de la dosimétrie d'irradiation peut être réalisée. Les deux fonctions injection-réception s'opèrent soit par l'intermédiaire d'un seul fil si l'antenne est à double fonction (excitation-détection sur la même antenne) soit sur deux fils si l'antenne est à simple fonction (excitation et détection sur des antennes séparées, l'excitation pouvant être une antenne commune à tous les points de mesure). Le signal reçu après excitation RPE est transmis par les moyens 22 à des moyens 24 qui permettent d'extraire du signal RPE obtenu un signal basse fréquence contenant la ou les phases adéquates (i.e. un signal en phase et/ou en quadrature de phase par rapport au signal d'excitation). Le signal basse fréquence est synchrone avec le champ magnétique basse fréquence de modulation de l'électroaimant. Enfin, ce signal est transmis à des moyens 26 d'extraction du signal RPE, en vue du traitement numérique par les moyens 14 et de l'asservissement de l'accord d'antenne.

Dans le cas où l'accord d'antenne s'effectue par une diode à capacité variable, l'asservissement de la fréquence de l'antenne se fait par l'intermédiaire de la liaison 34, la liaison 29 étant alors supprimée et le générateur 30 étant alors à fréquence fixe.

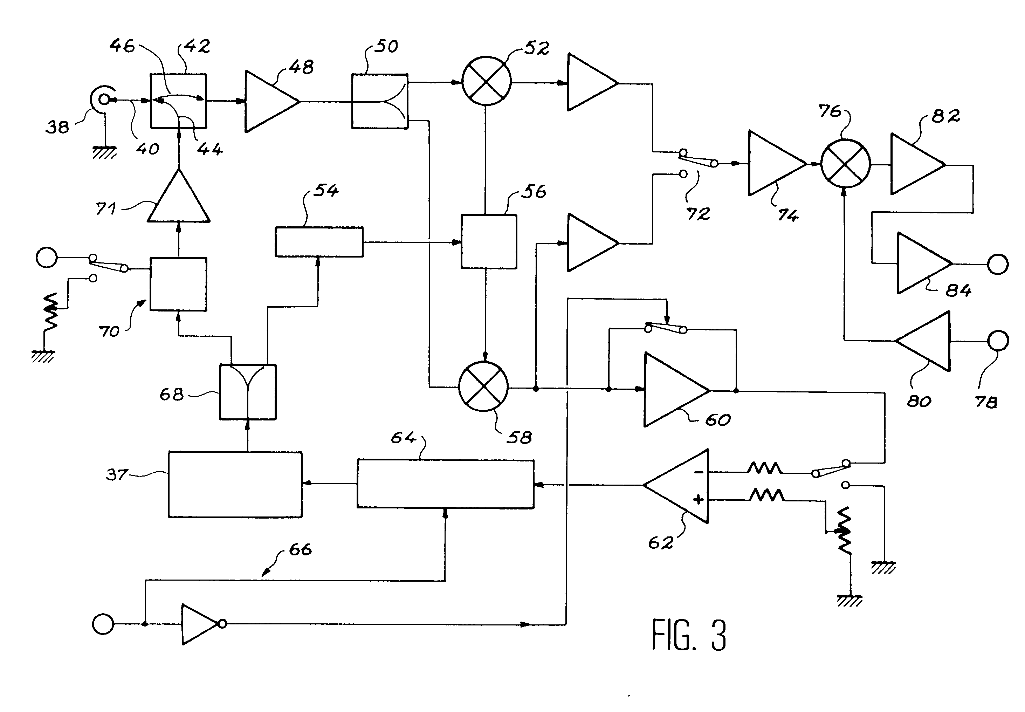

La figure 3 représente plus en détail un mode de réalisation des moyens 10 de commande d'une antenne accordée par VCO, dans le cas où la commande est réalisée à l'aide d'un oscillateur contrôlé en tension 37 appelé aussi pilote. Sur cette figure, l'antenne est désignée par la référence 38. Elle est connectée au circuit électronique RF par un câble coaxial 40 d'une impédance de 50 ohms, et elle permet d'exciter l'échantillon et de détecter le signal reçu à partir de celui-ci. Un circulateur 42 ou coupleur directionnel dissocie le signal d'excitation 44 du signal de détection 46. Le signal reçu après excitation est amplifié par un amplificateur 48 à faible bruit et est dirigé, par l'intermédiaire d'un diviseur 50 vers un mélangeur 52 qui effectue une extraction cohérente du signal basse fréquence portée par le signal radiofréquence (le corps étudié est soumis à un champ magnétique continu d'environ 200 Gauss modulé par un champ magnétique basse fréquence). Cette détection se fait en phase par interposition entre le pilote 37 et le mélangeur 52 d'une ligne à retard 54 de 50 ohms, qui compense les temps de propagation des signaux d'excitation et de détection. Un déphaseur 56 à 90° et une chaîne de détection identique à la première, constituée d'un mélangeur 58 dont une des entrées est alimentée par une partie du signal provenant de l'amplificateur 48 par l'intermédiaire du diviseur 50, permettent la mesure en quadrature. Le signal en quadrature est également utilisé à travers un intégrateur 60 (appelé aussi précédemment amplificateur d'erreur), dont la sortie est reliée à l'entrée négative d'un amplificateur différentiel 62. L'entrée positive de ce dernier est alimentée par une tension d'accord constante, et sa sortie permet d'asservir l'accord de l'antenne par l'intermédiaire du pilote VCO 37. Un échantillonneur bloqueur 64 et un circuit 66 permettent de bloquer l'asservissement pendant la mesure. Au cours de cette dernière, l'échantillonneur bloqueur 64 mémorise la tension du VCO 37 correspondant à la fréquence de l'accord d'antenne. Ceci permet de ne pas modifier les paramètres du signal pendant l'acquisition. Le signal d'excitation envoyé par le pilote VCO 37 passe par un diviseur 68, par un mélangeur à diodes 70 monté en atténuateur (ce qui permet de régler la puissance de ce signal d'excitation) puis par un amplificateur 70 pour être ensuite couplé à l'antenne 38.

Un commutateur 72 permet de choisir le signal (en phase ou en quadrature) qui va être traité en fonction des moyens 26 de traitements utilisés. Le signal choisi est amplifié par un amplificateur 74 dont la sortie est envoyée sur une entrée d'une détection synchrone 76. L'autre entrée de cette détection synchrone 76 est alimentée par une source de référence basse fréquence 78 (qui sert également à la modulation du champ induit par l'électroaimant), par l'intermédiaire d'un amplificateur 80. La sortie de cette détection synchrone 76 peut ensuite être filtrée par des moyens de filtrage 82, amplifiés par des moyens d'amplification 84 et est ensuite disponible pour le traitement numérique.

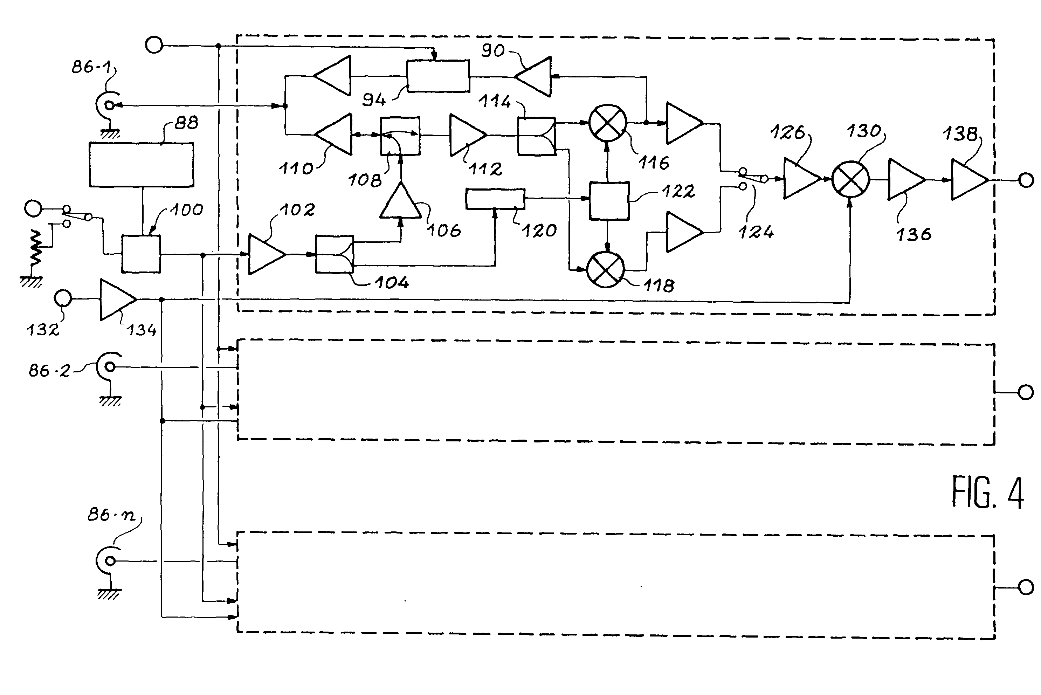

La figure 4 représente la chaîne électronique RF pour un système à pilote unique. Dans ce cas, on dispose de n antennes 86-1, 86-2,... 86-n. Chaque antenne est alimentée par un circuit qui fonctionne sur le même principe que le circuit qui vient d'être décrit ci-dessus, sauf pour le VCO qui est remplacé par un oscillateur fixe 88. Dans ce cas, l'asservissement de l'accord d'antenne se fait en modifiant la consigne de tension aux bornes d'une diode à capacité variable, située au voisinage de l'antenne en question, et toujours par l'intermédiaire d'un intégrateur 90 (appelé aussi amplificateur d'erreur) qui commande une entrée d'un échantillonneur-bloqueur 94. La puissance du signal d'excitation est, comme précédemment, ajustée par un mélangeur à diodes 100 monté en atténuateur. Le signal d'excitation passe successivement par un amplificateur 102, un diviseur 104, un deuxième amplificateur 106, un circulateur ou coupleur directionnel 108, et des moyens de filtrage 110. Le signal détecté est envoyé, par l'intermédiaire d'un amplificateur 112 et d'un diviseur 114 à deux mélangeurs 116, 118 dont une autre entrée est alimentée par le signal du pilote 88, par l'intermédiaire d'une ligne à retard 120 et d'un déphaseur 122 qui ont les mêmes fonctions que les éléments 54, 56 dans le circuit de la figure 3, déjà décrit ci-dessus. Là encore, un interrupteur 124 permet de sélectionner le signal de sortie (signal en phase ou signal en quadrature), qui est amplifié par un amplificateur 126 et qui passe ensuite dans une détection synchrone 130 dont l'autre entrée est alimentée par un signal de référence basse fréquence, à partir d'une source d'alimentation basse fréquence 132 et d'un amplificateur 134 (les éléments 132 et 134 sont communs à l'ensemble des antennes). Le signal de sortie de la détection synchrone 130 peut ensuite être filtré (moyens de filtrage 136) et amplifié (moyens d'amplification 138), pour être disponible pour un traitement numérique. Les circuits électroniques RF pour chacune des antennes 86-2,... 86-n sont identiques au circuit électronique RF pour l'antenne 86-1.

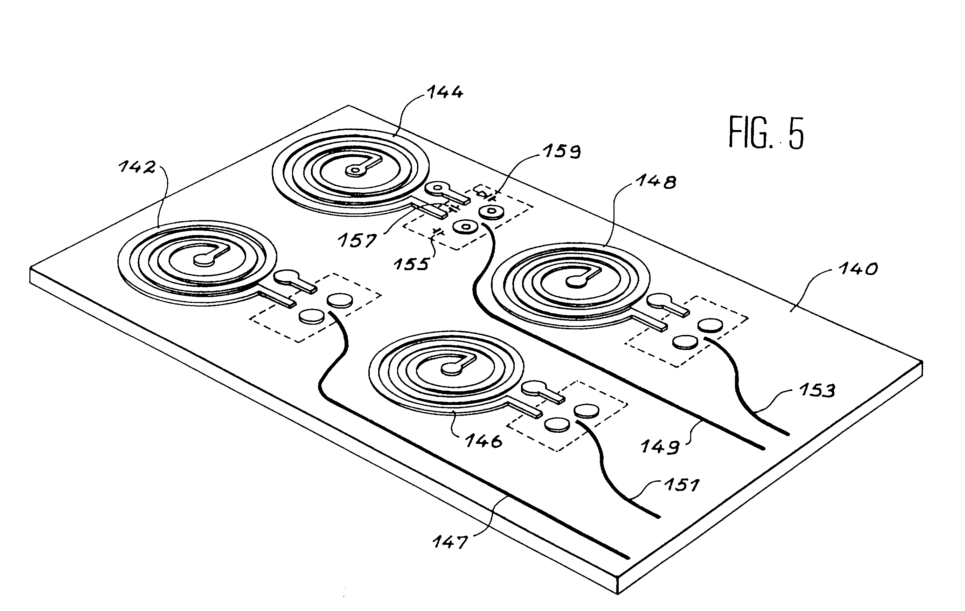

De préférence, on choisit comme antennes des antennes planes spirales "micro-strip" dites aussi antennes à onde de surface, qui présentent un diamètre d'environ 5 à 10 mm. Comme déjà décrit ci-dessus, on peut utiliser pour l'émission du signal RF vers le corps à étudier, une seule antenne combinée à plusieurs antennes de détection, ou plusieurs antennes combinées chacune à une antenne de détection. Dans ces cas, une pluralité d'antennes peut être rassemblée sur un support rigide, tel qu'illustré sur la figure 5. Sur cette figure, le support 140 a une forme rectangulaire, mais il peut, en principe, avoir n'importe quelle géométrie. Les références 142, 144, 146, 148 désignent chacune une antenne plane spirale du type à onde de surface, dont il a été question ci-dessus. Ces antennes sont alimentées par l'intermédiaire de câbles coaxiaux 147, 151, 149, 153 (50 ohms). Chaque câble peut être soudé directement sur l'antenne avec la technique appropriée à sa dimension.

Par ailleurs, il est possible de disposer des moyens d'accord, à proximité de chaque antenne. Comme illustré sur la figure 5, un condensateur d'adaptation 155, un condensateur d'accord 157, et une diode à capacité variable peuvent remplir cette fonction d'accord en fréquence, ainsi qu'il a été décrit ci-dessus. Si la diode à capacité variable est perturbée par le champ électrique RF et/ou par le champ magnétique basse fréquence, elle est placée non pas sur l'antenne elle-même, mais plutôt sur la carte qui porte le circuit électronique RF correspondant à l'antenne.

Par ailleurs, il est également possible de disposer de moyens d'accord et d'adaptation commandables à distance, mécaniquement ou électriquement, tels qu'une capacité motorisée ou une capacité piézoélectrique. Le support 140 peut être par exemple en verre. La technique de réalisation de l'ensemble support-antenne sera alors du type circuit imprimé sur verre époxy ou verre téflon.

Il est également possible de réaliser un assemblage de plusieurs antennes sur un support souple, tel que du kapton, le support pouvant alors être adapté à la forme particulière du corps à mesurer. On peut lui faire prendre par exemple la forme d'un gant, pour la détection de radicaux libres produits lors d'une irradiation accidentelle de la main, par exemple en manipulant une source radioactive. Les antennes sont alors réparties sur toute la surface du gant.

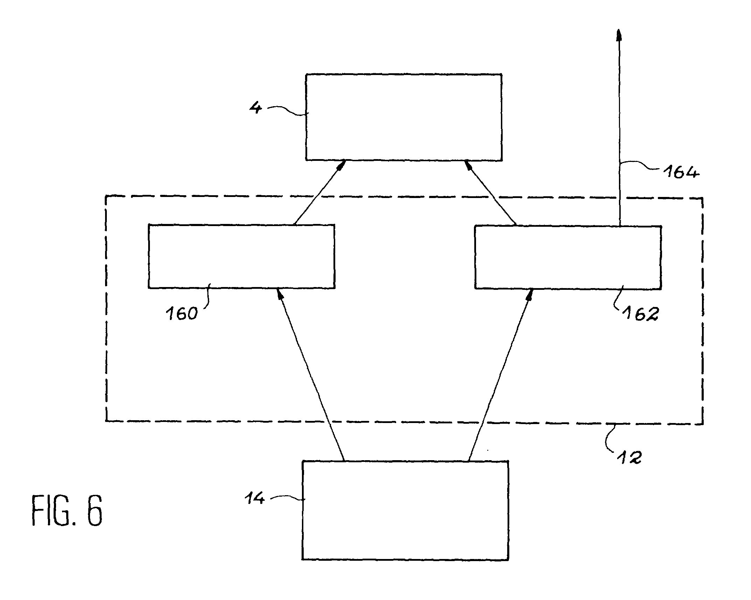

La figure 6 représente les moyens 12 (voir figure 1) de commande de l'aimant. Ces moyens 12 sont pilotés par les moyens 16 de traitement informatique, par l'intermédiaire des moyens 14 de commande. L'aimant 4 est dans ce cas un aimant résistif possédant un ou deux enroulements. Le ou les enroulements sont alimentés d'une part par un générateur de courant 160, et d'autre part par un générateur basse fréquence 162. Le générateur de courant 160 effectue un balayage en amplitude, ce qui produit une variation d'amplitude du champ magnétique auquel est soumis le corps 2. Lorsqu'il y a correspondance entre la valeur du champ magnétique et la fréquence du champ radiofréquence émis par l'antenne, il y a résonance RPE. Le générateur basse fréquence 162 est piloté en amplitude et en fréquence, et il permet de moduler le champ magnétique produit par la circulation du courant envoyé par le générateur 160. Par ailleurs, une sortie 164 de ce générateur basse fréquence sert de source de référence basse fréquence pour la détection synchrone basse fréquence réalisée par les circuits électroniques qui ont été décrits ci-dessus (voir références 76 et 130 pour la détection synchrone et 78 et 132 pour la source de référence basse fréquence sur les figures 3 et 4).

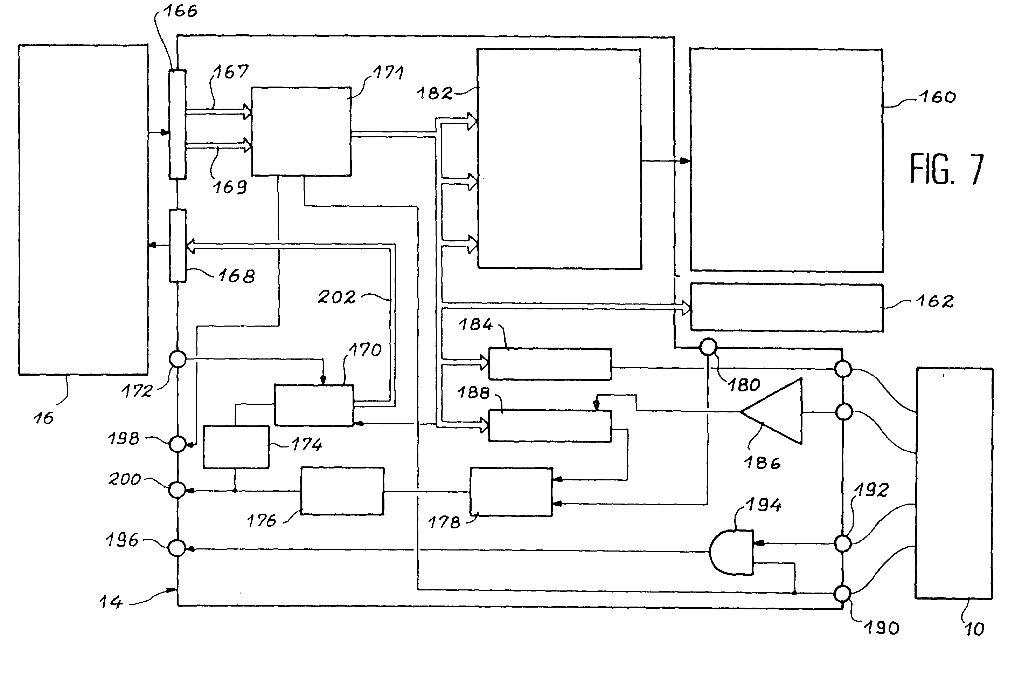

Un exemple de réalisation des moyens 14 est donné sur la figure 7. Ces moyens constituent une interface de dialogue entre les moyens 16 et les moyens 12 (i.e. 160 et 162, figure 6) et les moyens 10 (voir figure 1). Sur la figure 7, les référence 4, 10, 16, 160, 162 désignent les mêmes éléments que sur les figures précédentes.

Les moyens 16 sont reliés aux moyens 14 par des moyens d'entrée 166-sortie 168. L'entrée 166 communique, par des bus de liaison 167, 169, des informations d'adresses et de données à des moyens 171 de réception de ligne et de décodage d'adresses pour la lecture des adresses et des données. Ces informations sont ensuite transmises à des moyens de conversion numérique-analogique 182 pour la commande des moyens 160, ou 184 pour la commande du niveau R.F. transmis aux moyens de traitement analogiques 10, ou au générateur basse fréquence 162.

Un signal de début de fonctionnement des moyens 170 de conversion analogique-digital (12 bits) est envoyé par une entrée 172. La référence 174 désigne un échantillonneur-bloqueur. La référence 176 correspond aux éléments 82 et 84 de la figure 3 ou 136 et 138 de la figure 4. La référence 178 correspond aux moyens de détection synchrone 130 (figure 4) ou 76 (figure 3) et peut en outre comprendre des moyens de déphasage du signal délivré par le générateur B.F. 162. L'entrée 180 de ce signal correspond aux éléments désignés par les références 78 (figure 3) et 132 (figure 4).

Le signal reçu via les moyens 10 est transmis à un amplificateur bas bruit 186 et à un amplificateur à gain programmable qui correspondent aux moyens d'amplification désignés globalement par la référence 74 (ou 126) de la figure 3 (ou de la figure 4).

Les moyens 171 envoient également aux moyens 10, via la sortie 190, un signal d'arrêt de l'asservissement de l'accord d'antenne pendant la mesure. Un signal d'accord d'antenne est délivré par les moyens 10 sur une entrée 192 des moyens 14. Les deux signaux (arrêt de l'asservissement et accord d'antenne) sont envoyés sur une porte ET 194 dont la sortie 196 permet de tester si l'électronique d'acquisition de signaux est prête. Des sorties 198, 200 permettent de réaliser d'autres tests de fonctionnement (tests sur phase de calcul ou de mesure, notamment) . Un bus 202 transmet les données du convertisseur 170 aux moyens de sortie 168.

Un exemple d'application d'un procédé et d'un appareil selon l'invention est l'analyse de fruits irradiés ; une analyse avec un procédé et un appareil selon l'art antérieur (donc ne permettant pas d'imagerie) est décrite dans l'article de J. Raffi et al. cité en introduction.

Il va maintenant être décrit un exemple de procédé par lequel les moyens de traitement informatique 16 reconstituent, à partir des données reçues, une image d'une partie du corps étudié. On précise que, pour la suite, en chaque point de mesure est réalisé un ou plusieurs spectres, chaque spectre correspondant à un balayage du champ magnétique B, ce dernier prenant N valeurs successives. Par conséquent, chaque spectre comprend N couples de valeur (B, I) ou I est l'intensité du signal RPE pour la valeur du champ magnétique B.

Si on dispose de n points de mesure sur le corps étudié, on peut donc acquérir n spectres et former n tableaux de N couples de valeur (B, I).

Il est donc possible également d'attribuer chaque tableau de mesure, c'est-à-dire chaque spectre, à une position géographique donnée sur l'objet. Si on dispose d'un seul spectre pour chacun des n points de mesure, chaque spectre se voit attribuer une position (x, y) sur la surface de l'objet.

Par ailleurs on dispose, dans une zone mémoire des moyens 16, de catalogues de cartes préenregistrées, ou de modèles de référence préenregistrés issus d'expériences antérieures prises comme référence. Ces modèles de référence permettent de disposer de spectres correspondant à des niveaux d'irradiation connus.

On peut réaliser ensuite une comparaison, par exemple point à point, de chaque spectre avec une courbe de référence prise dans les modèles de référence préenregistrés. La comparaison peut consister par exemple à tester si un certain niveau de corrélation est atteint entre le spectre mesuré et le spectre de référence.

Si ce niveau de corrélation n'est pas atteint, on refait la même comparaison, mais avec l'amplitude maximum de la courbe de référence divisée par deux.

Si le niveau souhaité de corrélation n'est toujours pas atteint, l'amplitude maximum de la courbe de référence est divisée par 3, et la comparaison est poursuivie.

La division de l'amplitude maximum de la courbe de référence par des facteurs successifs k=1, 2, 3, 4,... est continuée jusqu'à l'obtention, pour une certaine valeur k₀, d'un niveau de corrélation satisfaisant entre le spectre mesuré et la courbe de référence dont l'intensité a été divisée par le facteur k₀.

On peut alors attribuer au spectre mesuré un niveau d'irradiation correspondant au niveau d'irradiation du spectre de référence corrigé par un facteur dépendant de k₀.

Chaque spectre correspondant à une position géographique donnée à la surface de l'objet, il est possible d'attribuer à cette position géographique le niveau d'irradiation ainsi calculé.

En vue de la représentation en dimension 2, on peut également attribuer un code de couleur qui correspond à ce niveau d'irradiation.

Il est ensuite possible de procéder à une représentation en dimension 2 d'un nuage de n points colorés, par exemple en relation avec une carte de référence.

Ces différentes étapes de procédé peuvent être réalisées par divers logiciels, déjà disponibles commercialement. Un tel logiciel est par exemple le logiciel MATHCAD (de MATHSOFT Inc., 201 Broadway, Cambridge, Massachusetts, 02139 USA).

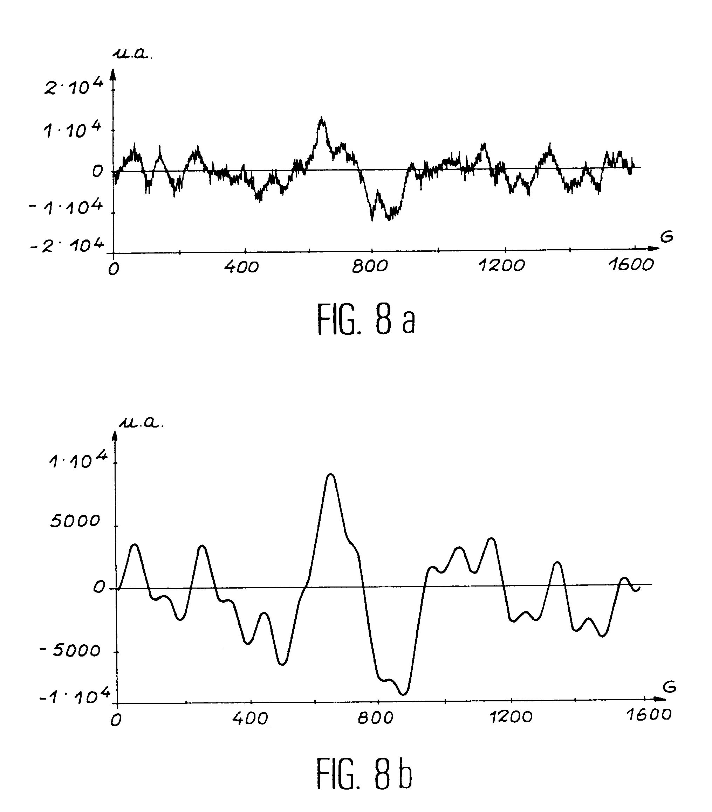

Un exemple de spectre mesuré (ou spectre à analyser) est donné sur la figure 8a. Cette figure donne l'amplitude du signal mesuré (en unités arbitraires) en fonction des différentes valeurs du champ magnétique B (en Gauss). Elle correspond à un échantillon irradié à 40 Gray.

La figure 8b est un exemple de modèle de référence tiré d'un catalogue. Ce modèle correspond à un niveau d'irradiation donné pour un certain corps, en un certain point de ce corps. Ce modèle de référence donne l'intensité du signal mesuré (en unités arbitraires) en fonction des variations du champ magnétique B (en Gauss).

La mise en oeuvre des étapes du procédé décrit ci-dessus est beaucoup plus rapide que la mise en oeuvre des procédés d'imagerie utilisant des techniques consistant à appliquer des champs de gradient pour sélectionner des zones à l'intérieur du corps dont on veut établir l'image, puisqu'il faut alors faire des acquisitions successives avant de pouvoir reconstituer l'image.

Les moyens de traitement et d'analyse des signaux mis en oeuvre dans l'invention prennent en compte la localisation spatiale des signaux. Il n'est pas nécessaire de recourir aux gradients de champ magnétique sur le corps à étudier pour obtenir l'information du positionnement des signaux RPE.

L'encombrement de l'appareil conforme à l'invention dépend du corps à étudier. Mais pour un corps donné, il est 5 à 10 fois plus petit que ceux de l'art antérieur.

Dans le cas particulier où l'objet à analyser est une main, ou un fruit, l'élément 4 (voir figure 1) a une taille de l'ordre de 50x30x30 cm, et l'électronique associée (i.e. les moyens 10, 14 et 12) tient dans un petit boîtier d'électronique.

## Revendications

1. Spectromètre à résonance paramagnétique électronique, sans gradient de champ magnétique, pour la dosimétrie d'irradiation d'un corps, caractérisé en ce qu'il comporte :
- des moyens (4) de production d'un champ magnétique,
- au moins une antenne plane (8, 28, 38, 86, 142, 144, 146, 148), destinée à être disposée sur le corps,
- des moyens (10) de transmission, à l'antenne, de signaux radiofréquences, pour exciter une résonance paramagnétique électronique (RPE) du corps,
- des moyens de réception (22) de signaux basse fréquence réémis par le corps en réponse à l'excitation RPE,
- des moyens (14, 16) de traitement et d'analyse des signaux basse fréquence reçus par les moyens de réception,
- des moyens (18) pour représenter une image (20) d'au moins une partie du corps étudié, à partir des signaux traités et analysés par les moyens de traitement et d'analyse.

2. Spectromètre selon la revendication 1, comportant également des moyens (162) pour moduler le champ magnétique.

3. Spectromètre selon l'une des revendications 1 ou 2, les moyens de traitement et d'analyse comportant également des moyens permettant de comparer les signaux traités et analysés à des signaux de référence.

4. Spectromètre selon l'une des revendications 1 à 3, l'antenne ou les antennes planes étant du type antenne spiralée.

5. Spectromètre selon l'une des revendications précédentes, le signal radiofréquence transmis à l'antenne (ou aux antennes) présentant une répartition spectrale dont au moins une partie est située en-dessous de 1 GHz.

6. Spectromètre selon la revendication 5, le signal radiofréquence présentant une répartition spectrale entre 250 et 600 MHz.

7. Spectromètre selon l'une des revendications précédentes, comportant une antenne d'émission et plusieurs antennes de détection.

8. Spectromètre selon l'une des revendications 1 à 6, présentant une antenne d'émission et une antenne de détection pour chaque point de mesure sur le corps à étudier.

9. Spectromètre selon l'une des revendications 1 à 6, au moins une antenne assurant la double fonction d'excitation et de détection.

10. Spectromètre selon l'une des revendications précédentes, comportant plusieurs antennes planes (142, 144, 146, 148) disposées sur un même support (140).

11. Spectromètre selon l'une des revendications 1 à 10, une ou plusieurs antennes étant associées à des moyens d'accord en fréquence.

12. Spectromètre selon la revendication 11, les moyens d'accord en fréquence étant situés à proximité de l'antenne.

13. Spectromètre selon la revendication 11 ou 12, les moyens d'accord en fréquence comportant un condensateur d'accord (157) et une diode à capacité variable (159).

14. Spectromètre selon la revendication 13, le condensateur d'accord et la diode à capacité variable étant intégrés sur un support commun avec l'antenne.

15. Spectromètre selon l'une des revendications 10 ou 14, le support étant un support rigide.

16. Spectromètre selon l'une des revendications 10 ou 14, le support étant un support souple.

17. Spectromètre selon l'une des revendications 11 ou 12, les moyens d'accord en fréquence comportant une capacité à commande mécanique ou motorisée, ou bien une capacité piézoélectrique.

18. Procédé d'imagerie d'un corps par résonance paramagnétique électronique, sans gradient de champ magnétique, caractérisé en ce qu'il comporte les étapes suivantes :
- création d'un champ magnétique dans lequel est plongé au moins une partie du corps à étudier,
- application de signaux radiofréquences à l'aide d'au moins une antenne plane pour exciter au moins une résonance paramagnétique électronique RPE du corps à étudier,
- prélèvement de signaux basse fréquence réémis par le corps en réponse à l'excitation RPE,
- traitement et analyse des signaux basse fréquence prélevés, en vue de former une image de ladite partie du corps,
- affichage de cette image.

19. Procédé selon la revendication 18, une modulation étant appliquée au champ magnétique.

20. Procédé selon l'une des revendications 18 ou 19, une comparaison étant réalisée entre des signaux traités et analysés et des signaux ou spectres de référence.

21. Procédé selon la revendication 18, les signaux radiofréquences appliqués au corps pour exciter une ou plusieurs résonances paramagnétiques électroniques ayant un spectre dont au moins une partie est en-dessous de 1 GHz.

22. Procédé selon la revendication 21, le spectre étant dans un domaine compris entre 250 et 600 MHz.
